Europäisches Patentamt

(19) European Patent Office

Office européen des brevets

(11) Publication number: **0 063 402**

**A1**

(12) **EUROPEAN PATENT APPLICATION**

(21) Application number: **82300058.3**

(22) Date of filing: **07.01.82**

(51) Int. Cl.³: **G 01 R 21/00**

(30) Priority: **21.04.81 US 256073**

(43) Date of publication of application:
**27.10.82 Bulletin 82/43**

(84) Designated Contracting States:
**AT BE CH DE FR GB IT LI LU NL SE**

(71) Applicant: **SCIENTIFIC COLUMBUS, INC.**
**1900 Arlingate Lane**
**Columbus Ohio, 43228(US)**

(72) Inventor: **Haferd, James E.**
**3827 Habitat Drive**
**Columbus Ohio 43228(US)**

(72) Inventor: **Friend, Harley L.**
**3614 Rochfort Bridge, Dr.**
**Columbus Ohio 43220(US)**

(74) Representative: **Wombwell, Francis et al,**
**Potts, Kerr & Co. 15, Hamilton Square**
**Birkenhead Merseyside L41 6BR(GB)**

(54) **Multi-function electricity billing meter.**

(57) A multi-function electricity revenue meter is disclosed which converts instantaneous currents and voltages for each phase to digital form by sampling appropriately stepped down analog signals. The current and voltage digital sample signals provide the basic data from which a multiplicity of other revenue metering quantities are computed. The meter uses a plurality of voltage and current transformers for reducing or providing signals proportional to the instantaneous voltages and currents. These analog signals are applied to an analog to digital converter which provides outputs representing the instantaneous values of the voltages and currents of the phases of the power system. A central processing unit is connected to the analog to digital converter as well as appropriate RAM and ROM memory, a real-time clock/calendar and suitable data output means for computing and outputting the electricity revenue metering quantities.

FIG. I

## MULTI-FUNCTION ELECTRICITY BILLING METER

### Technical Field

This invention relates to electricity metering and more particularly relates to a solid state electricity revenue meter which generates a multiplicity of different functions or quantities which are useful in determining the cost of the electrical energy supplied to a customer.

### Background Art

In the electrical energy industry the various quantitative measuresments which determine customer billing are traditionally obtained from a variety of different devices. Each device is designed and constructed to meter a particular quantity. For example, the historic Ferraris rotating meter is used in a variety of forms to measure real energy or reactive energy (KVAR) and with uniquely designed attachments, to measure related power demand quantities. Kw and KVAR transducers when coupled with appropriate integrating means are also used for these purposes. Inherent in the electromechanical structure or electronic circuitry of each such device are the mathematical operations which are necessary to determine the particular quantity.

For example, the rotating Ferraris meter inherently provides a cumulative total number of output revolutions which is proportional to the product of current, voltage, the cosine of the angle between them and time in hours. Similarly, a KVAR transducer provides an output which is proportional to the product of voltage, current and the sine of the angle between them.

With conventional technology a power company orders and installs those devices or transducers which provide the quantities which are desired. Some manufacturers have combined more than one type of transducer into an aggregation of such devices in a single piece of equipment which may also have additional features.

Patent 4,218,737 shows two different transducers combined in a circuit which converts each of their outputs to digital form and then processes, stores, communicates and displays the processed data.

## Brief Disclosure of the Invention

This invention has no transducer or device which directly generates any of the functions or quantities which are used for billing purposes. Instead, the present invention provides electronic solid state circuitry which samples the basic analog quantities of instantaneous current and instantaneous voltage as they appear in the power distribution system at some interconnection terminal, such as between a power line and the energy consuming equipment of the customer. Those current and voltage samples are converted directly to digital form. Data signals representing the voltage and the current samples are then processed by a data processing unit to provide the desired quantities, such as for example total kilowatt hours, peak kilowatt demand, total kilovar hours, average kilovars, peak KVA demand, total KVA hours, kilowatt and KVA demand peak average, power factor average, power factor at demand peak, total KQh, etc.

One advantage of the invention is that a single meter can be installed to obtain numerous revenue related readings where several conventional meters and attachments have otherwise traditionally been required. The computing portion of a meter embodying the invention may be provided with interchangeable or replaceable ROMs which contain data representing the current rate structure for a particular company and a specific customer.

The circuitry of the present invention permits a unit to be constructed which meters all the quantities which are desired for revenue billing purposes with a single unit which is physically and electrically compatible with conventional Ferraris meters so that a meter embodying the invention may directly replace one or more traditional Ferraris meters without requiring any other modification of the customer's preexisting installation.

## Brief Description of the Drawings.

Fig. 1 is a block diagram illustrating the preferred embodiment of the invention.

Fig. 2 is an oscillogram illustrating the sampling technique used in the operation of the preferred embodiment.

Fig. 3 is a table of equations illustrating the data processing which is used to convert the voltage and current samples to some of the most commonly used metering quantities.

In describing the preferred embodiment of the invention which is illustrated in the drawings, specific terminology will be resorted to for the sake of clarity. However, it is not intended that the invention be limited to the specific terms so selected and it is to be understood that each specific term includes all technical equivalents which operate in a similar manner to accomplish a similar purpose. For example, the word connected or terms similar thereto are often used. They are not limited to direct connection but include connection through other circuit elements where such connection is recognized as being equivalent by those skilled in the art.

## Detailed Description of the Best Mode

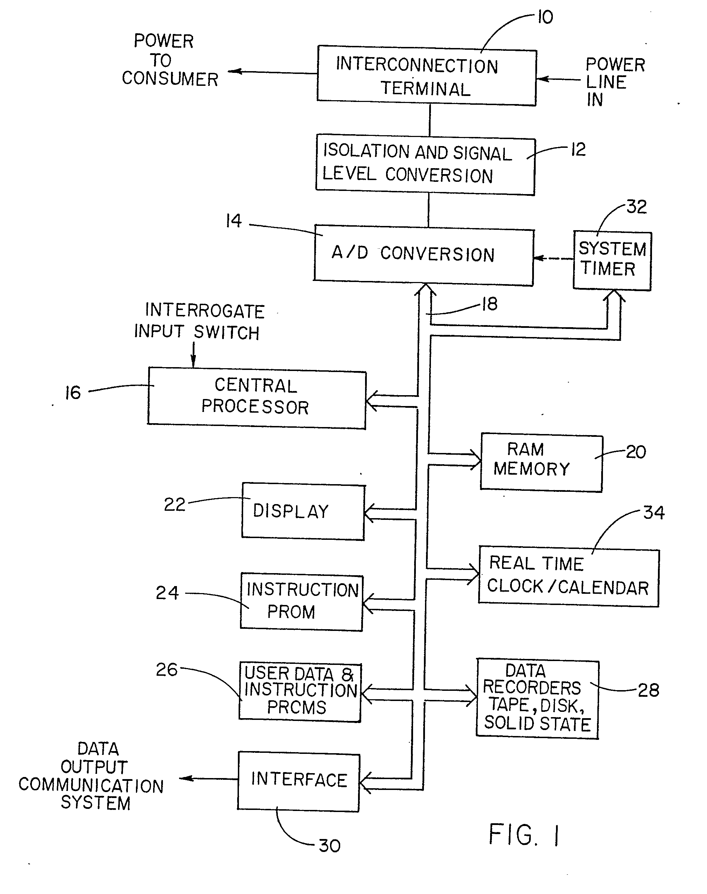

Referring to Fig. 1, electrical power from a distribution system is provided to some interconnection terminal 10 and from the interconnection terminal 10 is supplied to the energy consuming equipment of the customer. While interconnection terminal 10 may be either custom designed or a conventional type, usually it is either an S-type mounting for socket connection to a Ferraris-type meter or an A-type mounting for direct connection of the line and the load conductors.

An isolation and signal level conversion means 12 has its input connected to the interconnection terminal 10 and provides at its output a plurality of analog signals which are proportional to the instantaneous voltage and current of the phases of the power line. Preferably, these are conventional transformers which provide isolation and reduce the voltage and current signals to a workable level which is compatible with solid state circuitry.

The present invention will operate with single and multiphase power distribution systems. In a single phase system there will be one or two current transformers and one or two voltage transformers. However, for a conventional three-phase system, the isolation and signal level conversion means 12 will consist of two or three voltage stepdown transformers and two or three current transformers. Therefore, in the three-phase system the output of the isolation and signal level conversion means will consist of two or three output current signals which are proportional to the instantaneous currents of the power distribution system at the interconnection terminal 10 and two or three voltage signals which are proportional to the three voltages of the three-phase system at the interconnection terminal 10.

The output of the isolation and signal level conversion means 12 is applied to an analog to digital converter or A/D conversion means 14. The analog to digital conversion means 14 is controlled by a central processing unit 16. The A/D conversion means 14 converts the analog signals which are applied to its input, such as the three current and three instantaneous voltage signals for a three-phase system to digital data signals representing instantaneous values of the voltages and of the currents for the three phases.

Thus, for example, the output of the A/D conversion means 14 for a three phase system might consist of three current and three voltage data words which are applied to the data portion of a data, address and control bus 18 in accordance with conventional data processing design principles.

The central processing unit 16 is also connected through the bus 18 to a RAM memory 20, a display 22, a programmable read-only memory or PROM 24 and a second PROM 26.

Two PROMs 24 and 26 are used so that the PROM 24 may be permanently installed and contains instructions and data which are common to usage of the multi-function revenue meter by all users. The PROM 26, however, is replaceable and contains instructions and data for a particular installation.

The bus 18 is also connected to data recording mechanisms such as tapes, discs, and solid state memories which may be referred to as a data recorder 28 and to conventional interfacing circuitry 30 to permit transmission of the data through a communication system.

A system timer 32 is connected to the bus 18 and may be connected to the A/D conversion means 14 depending upon the type of A/D converter used. A real-time calendar/clock 34 is also connected to the bus 18 and is needed for computing the time based quantities.

The manner of connecting a central processor through a bus to associated RAM and ROM memories, output devices and the other described elements is well known to those skilled in the art and therefore is not disclosed in further detail.

Similarly since a variety of A/D conversion means have been described in the prior art, the particular circuit used in the present invention is not described in detail. However, it is preferred that the digital conversion means 14 be of the sample and hole type. Preferably a plurality of angularly spaced samples are taken at different angular positions along the approximately sinusoidal signals representing the voltages and current described above. Each voltage sample is taken simultaneously with an associated current sample so that the samples are obtained as simultaneous pairs. In a three phase system the samples are taken as three simultaneous sets of simultaneous i and v pairs.

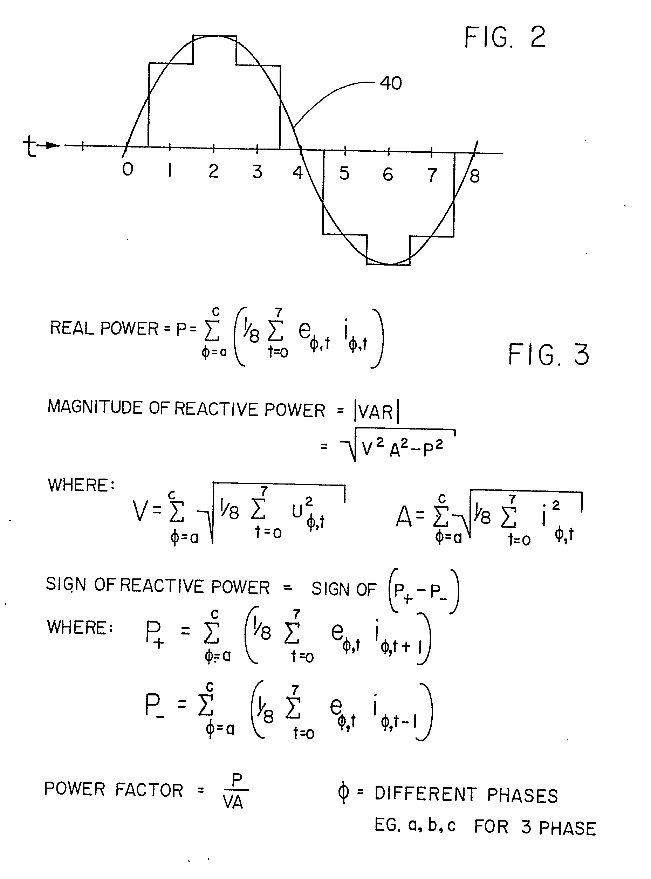

Fig. 2 illustrates a typical, approximately sinusoidal, instantaneous current or voltage signal 40. It is preferred that eight samples of the signal be taken for each cycle of the 50Hz or 60Hz power signal. The samples are specifically, angularly spaced along the cycle. Subsequent sample sets may not be angularly coincident with the preceding sample sets but will also be specifically angularly spaced along the cycle. Preferably the samples are uniformly angularly spaced.

However, since one cycle of 60Hz power has a period of approximately 17 milliseconds, all eight samples are not taken during the same cycle. Because the signal is periodic, the samples can be taken during subsequent, representative repetitive cycles at specific, angularly spaced positions in the cycle.

For example, the first sample may be taken at $45^\circ$ following the positive-going zero crossover of one cycle. The second sample might be taken $90^\circ$ after the positive-going zero crossover of the first subsequent cycle and the third sample taken $135^\circ$ after the positive-going zero crossover of the second subsequent cycle and so forth and so on. In this manner the samples are taken at an integral number of phase angles which are specifically angularly spaced along representative repetitive cycles of each of the current and voltage analog signals from the amplitude reduction means 12.

For each of the samples, for example the eight samples, representing a sample set, illustrated in Fig. 2, a digital data word is provided at the output of the A/D conversion means 14. Thus, in a three phase system 48 such data words will be utilized to represent the voltage and current samples for the three phases.

The table of Fig. 3 illustrates how these samples are processed by the central processing unit 16 for computing some of the more common quantities used in revenue metering.

For example, real energy may be computed for the time interval over which the sample is taken. It is computed for each phase by summing the products of each voltage sample and its simultaneously taken current sample for all of the eight sample positions then dividing that sum by the number of samples, such as eight.    This is done for each phase and then the three results are summed.    The computed increment of real energy is then stored in memory along with data representing the time at which the quantity was determined.    The same computing techniques may be applied to the other conventional revenue metering quantities for which there are standard definitions and algebraic statements well known to those skilled in the art.

Similarly, the mathematical statements defining other quantities and algorithms based on rate structure may be implemented by the processor and its associated memories and the date may be displayed and/or communicated as desired

It is to be understood that while the detailed drawings and specific examples given describe preferred embodiments of the invention, they are for the purposes of illustration only, that the apparatus of the invention is not limited to the precise details and conditions disclosed and that various changes may be made therein without departing from the spirit of the invention which is defined by the following claims.

### CLAIMS

1. An electricity billing meter for connection to the interconnection terminals between either a power line and the energy consuming equipment of a customer, or two power lines at their junction at an interchange tie point, said meter comprising:

(a) an isolation and signal level conversion means having its inputs connected to said interconnection terminal for providing, at its outputs, a plurality of analog signals which are proportional to the instantaneous voltages and are proportional to the instantaneous currents of the phases of said power line;

(b) analog to digital conversion means having its input connected to the output of said isolation and signal level conversion means for providing, at its output, digital data signals representing instantaneous values of the voltage and of the current for the phases of said power line;

(c) a central processing unit connected to a data, address and control bus which is connected to the output of said A/D conversion means for controlling and receiving data signals from said A/D conversion means and for processing said data signals;

(d) memory means including RAM and ROM data storage means connected to said bus;

(e) real-time clock means connected to said bus; and

(f) data output means connected to said bus for outputting data resulting from the processing of data from said A/D conversion means.

2. A billing meter in accordance with claim 1 wherein said analog to digital conversion means is connected to said system timer and is a sample and hold type of A/D conversion means.

3. A billing meter in accordance with claim 1 wherein said memory means includes at least one main program storage PROM and a physically separate user data and special instruction PROM.

4. A billing meter in accordance with claim 1 wherein said data output means includes a visual display and an interface means
for providing data output in serial form.

5. A billing meter in accordance with claim 1 wherein said analog
to digital conversion means is connected to said system timer and
is a sample and hole type of A/D conversion means; wherein said
memory means includes at least one main program storage PROM
and a physically separate user data and special instruction PROM;
and wherein said data output means includes a visual display
and an interface means for providing data output in serial form.

6. A method for metering electrical parameters at a point in an
electrical power transmission system, said method comprising:

(a) sampling and converting to a digital signal an analog
signal which is proportional to the instantaneous voltage
of each phase of said transmission system at said point
in said transmission system;

(b) sampling and converting to a digital signal an analog
signal which is proportional to the instantaneous current
for the phases of said transmission system, said sampling
of said voltage and current signals being performed
substantially simultaneously;

(c) storing said digital sample signals; and

(d) arithmetically processing said stored signals to
generate digital signals representing at least one of said
parameters.

7. A method in accordance with claim 6 wherein said samples
are taken at an integral number of phase angles uniformly
angularly spaced along representative repetitive cycles
of each of said analog signals.

8. A method in accordance with claim 7 wherein said processing
includes metering real energy during a time interval by summing
for each phase the product of said integral number of instantaneous
digital voltage and current signals for each pair of simultaneous
current and voltage signals, averaging said sum over said number
of samples and adding said sums for each phase.

9. A method for electricity distribution system metering comprising:

(a) periodically sampling voltages and currents of said system at each of a plurality of sample positions which are angularly spaced along a composite cycle of said electricity to provide a group of samples;

(b) converting said group of voltage and current samples to digital data form; and

(c) machine computing selected electricity metering quantities from said digital samples for each of said periods.

10. A method in accordance with claim 9 wherein some of said computed quantities for each sampling period are cumulatively summed.

11. A method in accordance with claim 10 wherein the sample positions for each of said group of samples are uniformly angularly spaced along said composite cycle.

FIG. 1

FIG. 2

40

$$\text{REAL POWER} = P = \sum_{\phi=a}^{c} \left( \frac{1}{8} \sum_{t=0}^{7} e_{\phi,t} \; i_{\phi,t} \right)$$

FIG. 3

$$\text{MAGNITUDE OF REACTIVE POWER} = |VAR|$$
$$= \sqrt{V^2 A^2 - P^2}$$

WHERE:
$$V = \sum_{\phi=a}^{c} \sqrt{\frac{1}{8} \sum_{t=0}^{7} u_{\phi,t}^2} \qquad A = \sum_{\phi=a}^{c} \sqrt{\frac{1}{8} \sum_{t=0}^{7} i_{\phi,t}^2}$$

$$\text{SIGN OF REACTIVE POWER} = \text{SIGN OF} \left( P_+ - P_- \right)$$

WHERE:
$$P_+ = \sum_{\phi=a}^{c} \left( \frac{1}{8} \sum_{t=0}^{7} e_{\phi,t} \; i_{\phi,t+1} \right)$$

$$P_- = \sum_{\phi=a}^{c} \left( \frac{1}{8} \sum_{t=0}^{7} e_{\phi,t} \; i_{\phi,t-1} \right)$$

$$\text{POWER FACTOR} = \frac{P}{VA} \qquad \phi = \text{DIFFERENT PHASES}$$
$$\text{EG. a, b, c FOR 3 PHASE}$$

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | US-A-4 077 061 (JOHNSTON et al.) <br> *Column 6, line 24 - column 8, line 30; column 11, lines 54-65; figure 1* | 1-6 | G 01 R 21/00 |
| Y | EP-A-0 014 038 (SOUTH EASTERN ELECTRICITY BOARD) <br> *Claim 1* | 7-11 | |
| Y | FR-A-2 449 285 (LEEDS & NORTHRUP) <br> *Claim 1* | 7-11 | |
| D,A | US-A-4 218 737 (BUSCHER et al.) <br><br> *Abstract; figure 1* | | |

TECHNICAL FIELDS
SEARCHED (Int. Cl. ³)

G 01 R

The present search report has been drawn up for all claims

| Place of search <br> THE HAGUE | Date of completion of the search <br> 13-07-1982 | Examiner <br> KORAHNKE G.J. |
|---|---|---|